# EUROPEAN PATENT SPECIFICATION

(11) **EP 2 731 993 B1**
(45) Date of publication and mention of the grant of the patent: **30.08.2023**
(21) Application number: 12811953.4
(22) Date of filing: 12.07.2012
(51) Int. Cl.: C08L 63/00, C08G 59/22, C08K 3/00, H05K 7/20, H05K 1/05, H05K 1/03

(54) **EPOXY RESIN COMPOUND AND RADIANT HEAT CIRCUIT BOARD USING THE SAME**
EPOXIDHARZZUSAMMENSETZUNG UND STRAHLUNGSWÄRMELEITERPLATTE DAMIT
COMPOSITION DE RÉSINE ÉPOXYDE ET CARTE DE CIRCUIT IMPRIMÉ À CHALEUR RAYONNANTE L'UTILISANT

(30) Priority: 12.07.2011 KR 20110069138; 16.12.2011 KR 20110136871
(43) Date of publication of application: 21.05.2014
(73) Proprietor: LG Innotek Co., Ltd., Seoul, 04637 (KR)
(72) Inventor: KIM, Eun Jin, Seoul 100-714 (KR); KIM, Hae Yeon, Seoul 100-714 (KR); MOON, Sung Bae, Seoul 100-714 (KR); PARK, Jae Man, Seoul 100-714 (KR); PARK, Jeung Ook, Seoul 100-714 (KR); PARK, Hyun Gyu, Seoul 100-714 (KR); YOON, Jong Heum, Seoul 100-714 (KR); CHO, In Hee, Seoul 100-714 (KR); GIANG, Thanh Kieu, Suwon-si, Gyeonggi-do 440-746 (KR); KIM, Jin Hwan, Seoul 137-779 (KR)
(74) Representative: Novagraaf Technologies
(86) International application number: PCT/KR2012/005547
(87) International publication number: WO 2013/009114

(56) References cited:
- CN-A- 1 958 719
- CN-A- 101 585 821
- JP-A- H0 288 623
- JP-A- 2004 035 762
- JP-A- 2004 331 811
- JP-A- 2009 242 572
- JP-A- 2010 007 040
- JP-A- 2010 070 720
- JP-A- 2010 132 825
- JP-A- 2010 174 134
- JP-A- 2011 020 365
- US-A1- 2004 224 163
- US-B1- 6 255 409
- MIKROYANNIDIS J A: "SYNTHESIS, CHARACTERIZATION AND POLYMERIZATION OF NEW EPOXY COMPOUNDS CONTAINING AZOMETHINE LINKAGES", MAKROMOL. CHEM AND PHYSICS, WILEY, vol. 190, no. 8, 1 August 1989 (1989-08-01), pages 1867-1879, XP000102253, ISSN: 0025-116X, DOI: 10.1002/MACP.1989.021900812

## Description

### Technical Field

The technical field of the present application is about epoxy resin compositions and radiant heat circuits boards.

### Background Art

The present disclosure relates to an epoxy resin compound, and more particularly, to an epoxy resin for an insulating layer of a radiant heat circuit board.

A circuit board includes an electric insulation board and a circuit pattern formed on the electric insulation board. Such a circuit board is used for mountino components such as electronic components thereon.

Such electronic components may include a heat-generating device such as a light emitting diode (LED) that generates a large amount of heat. Heat generated from such as a heat-generating device increases the temperature of a circuit board and causes malfunction and reliability problems of the heat-generating device.

Accordingly, a radiant heat structure is important for dissipating heat from an electronic component to the outside of a circuit board, and the thermal conductivity of an insulating layer formed on the circuit board has a large influence on heat dissipation. The thermal conductivity of an insulating layer can be increased by filling an inorganic filler in the insulating layer at a high density, and an epoxy resin having a low viscosity is proposed as an inorganic filler.

JP 2010 070720 A discloses, in its Example 6, a composition according to the preamble of claim 1.

US 6255409 B1 discloses an epoxy resin composition including a crystalline epoxy resin and an amorphous epoxy resin.

CN 1958719 A discloses a thermoset liquid crystal composition including a Schiff base liquid crystal epoxy resin that can be used to make printed circuit boards but does not discuss thermal conductivity. **Disclosure of Invention**

### Technical Problem

Resins such as Bisphenol A type epoxy resin and bisphenol F type epoxy resin are generally used as low viscosity epoxy resins. Since such epoxy resins are difficult to handle because such epoxy resins are liquid at room temperature and are disadvantageous in terms of heat resistance, mechanical strength, and toughness.

### Solution to Problem

According to an embodiment of the present invention, there is provided an epoxy resin composition as recited in claim 1.

According to another embodiment of the present invention, there is provided a radiant heat circuit board with an improved thermal efficiency as recited in claim 3

Further advantageous embodiments are recited in the dependent claims 2 and 4.

### Advantageous Effects of Invention

According to the present disclosure, thermal conductivity can be increased by using the epoxy resin having a mesogen structure that facilitates crystallizability. In addition, a high radiant heat board can be provided by using the epoxy resin as an insulating material for a printed circuit board.

In addition, the epoxy resin has high thermal conductivity, low absorbency, low thermal expansibility, and high heat resistance.

The details of one or more embodiments are set forth in the accompanying drawings and the description below. Other features will be apparent from the description and drawings, and from the claims.

### Brief Description of Drawings

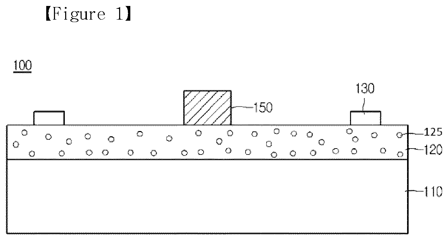

Fig. 1 is a cross-sectional view illustrating a radiant heat circuit board according to an embodiment.

### Best Mode for Carrying out the Invention

Embodiments will now be described in detail with reference to the accompanying drawings in such a manner that the technical idea of the present disclosure may easily be carried out by a person of ordinary skill in the art. However, the scope of the present disclosure is not limited to the embodiments but can be realized in different forms.

In the specification, when it is described that one comprises (or includes or has) some elements, it should be understood that it may comprise (or include or have) only those elements, or it may comprise (or include or have) other elements as well as those elements if there is no specific limitation.

In the drawings, regions not relating to descriptions are omitted for clarity in description, and layers and regions are exaggerated for clarity. Throughout the specification, like reference numerals denote like elements.

It will be understood that when a layer, a film, a region, or a plate is referred to as being on another layer, film, region, or plate, it can be directly on the other layer, film, region, or plate, or intervening layers, films, regions, or plates may also be present. However, if a layer, a film, a region, or a plate is referred to as being directly on another layer, film, region, or plate, there is not intervening layer, film, region, or plate.

The present disclosure provides an epoxy resin compound having an improved thermal conductivity owing to high crystalline characteristics.

The crystalline epoxy resin compound of the present disclosure includes an epoxy resin, a curing agent, and an inorganic filler as main components.

The epoxy resin includes at least 50 wt% of crystalline epoxy resin.

The crystalline epoxy resin is expressed by the following Chemical Formula.

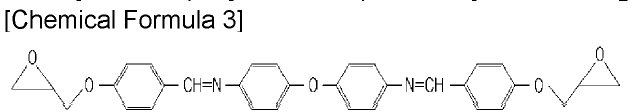

If the content of the crystalline epoxy resin is less than the above-mentioned value, effects such as an increase in thermal conductivity are reduced because the epoxy resin is not crystallized when hardened.

The epoxy resin further includes a general amorphous epoxy resin in which a molecule has at least two epoxy groups as well as the crystalline epoxy resin which is an essential component.

Examples of the amorphous epoxy include: bisphenol A; 3,3',5,5'-tetramethyl-4,4'-dihydroxydiphenylmethane; 4,4'-dihydroxydiphenylsulfone; 4,4'-dihydroxydiphenylsulfide; 4,4'-dihydroxydiphenylketone; fluorenbisphenol; 4,4'-biphenol,3,3',5,5'-tetramethyl-4,4'-dihydroxybiphenyl; 2,2'-biphenol; resorcin; catechol; t-butylcatechol; hydroquinone; t-butylhydroquinone; 1,2-dihydroxynaphthalene; 1,3-dihydroxynaphthalene; 1,4-dihydroxynaphthalene; 1,5-dihydroxynaphthalene; 1,6-dihydroxynaphthalene; 1,7-dihydroxynaphthalene; 1,8-dihydroxynaphthalene; 2,3-dihydroxynaphthalene; 2,4-dihydroxynaphthalene; 2,5-dihydroxynaphthalene; 2,6-dihydroxynaphthalene; 2,7-dihydroxynaphthalene; 2,8-dihydroxynaphthalene; allylated compounds or polyallylated compounds of the dihyroxynaphthalene; divalent phenols such as allylated bisphenol A, allylated bisphenol F, allylated phenol novolac; phenols having a valence of three or more such as phenol novolac, bisphenol A novolac, o-cresol novolac, m-cresol novolac, p-cresol novolac, Xylenole novolac, poly-p-hydroxysyrene, tris-(4-hydroxyphenyl)methane, 1,1,2,2-tetrakis(4-hydroxyphenyl)ethane, fluoroglycinol, pyrogallol, t-butylpyrogallol, allylated pyrogallol, polyallylated pyrogallol, 1,2,4-benzenetriol, 2,3,4-trihydroxybenzophenon, phenolaralkyl resin, naphthol aralkyl resin, dicyclophenadiene-based resin; and glycidyl etherficated compounds derived from halogenated bisphenols such as tetrabromobisphenol A. For example, the epoxy resin may include a combination of two or more of the listed amorphous epoxy resins.

The curing agent used for the epoxy resin compound of the present disclosure may be any of generally known epoxy resin curing agent. For example, the curing agent may be a phenol-based curing agent.

The phenol-based curing agent includes a phenol resin in addition to a phenol compound.

Examples of the phenol-based curing agent includes bisphenol A, bisphenol F, 4,4-dihydroxydiphenylmethane, 4,4-dihydroxyphenylether, 1,4-bis(4-hydroxyphenoxy)benzene, 1,3-bis(4-hydroxyphenoxy)benzene, 4,4-dihydroxydiphenylsulfide, 4,4-dihydroxydiphenylketone, 4,4-dihydroxydiphenylsulfone, 4,4-dihydroxybiphenyl, 2,2-dihydroxybiphenyl, 10-(2,5-dihydroxyphenyl)-10H-9-oxa-10-phosphaphenanthrene-10-oxide, phenol novolac, bisphenol A novolac, o-cresol novolac, m-cresol novolac, p-cresol novolac, Xylenole novolac, poly-p-hydroxysyrene, hydroquinone, resorsin, catechol, t-butylcatechol, t-butyl hydroquinone, fluoroglycinol, pyrogallol, t-butylpyrogallol, allylated pyrogallol, polyallylated pyrogallol, 1,2,4-benzenetriol, 2,3,4-trihydroxybenzophenone, 1,2-dihydroxynaphthalene, 1,3-dihydroxynaphthalene, 1,4-dihydroxynaphthalene, 1,5-dihydroxynaphthalene, 1,6-dihydroxynaphthalene, 1,7-dihydroxynaphthalene, 1,8-dihydroxynaphthalene, 2,3-dihydroxynaphthalene, 2,4-dihydroxynaphthalene, 2,5-dihydroxynaphthalene, 2,6-dihydroxynaphthalene, 2,7-dihydroxynaphthalene, 2,8-dihydroxynaphthalene, allylated compounds or polyallylated compounds of the dihyroxynaphthalene, allylated bisphenol A, allylated bisphenol F, allylated phenol novolac, and allylated pyrogallol.

At least two curing agents may be mixed and then used as the curing agent.

Meanwhile, a generally known curing agent may be used in addition to the phenol-based curing agent. Examples of generally known curing agent include an amine-based curing agent, an acid anhydride-based curing agent, a phenol-based curing agent, a polymercaptan-based curing agent, a polyaminoamide-based curing agent, an isocyanate-based curing agent, and a block isocyanate-based curing agent. The mixing ratio of the above curing agents may be properly selected according to the type of curing agent to be mixed or physical properties of a thermal conductive epoxy resin product.

Examples of the amine-based curing agent include aliphatic amines, polyetherpolyamines, cycloaliphatic amines, and aromatic amines. Examples of the aliphatic amines include ethylene diamine, 1,3-diaminopropane, 1,4-diaminopropane, hexamethylenediamine, 2,5-dimethylhexamethylenediamine, trimethylhexamethylenediamine, diethylenetriamine, aminobispropylamine, bis(hexamethylene)triamine, triethylenetetramine, tetraethylenephentamine, pentaethylenehexamine, N-hydroxyethylethylenediamine, and tetra(hydroxyethyl)ethylenediamine. Examples of the polyetherpolyamines include triethyleneglycoldiamine, tetraethyleneglycoldiamine, diethyleneglycolbis(propylamine), polyoxypropylenediamine, and polyoxypropylenetriamines. Examples of the cycloaliphatic amines include isophorone diamine, metacendiamine, N-aminoethylpiperazine, bis(4-amino-3-methyldicyclohexyl)methane, bis(aminomethyl)cyclohexane, 3,9-bis(3-aminopropyl)2,4,8,10-tetraoxaspiro(5,5)undecane, and norbornen diamine. Examples of the aromatic amines include tetrachloro-p-xylylenediamine, m-xylylenediamine, p-xylylenediamine, m-phenylenediamine, o-phenylenediamine, p-phenylenediamine, 2,4-diaminoanisole, 2,4-toluenediamine, 2,4-diaminodiphenylmethane, 4,4'-diaminodiphenylmethane, 4,4'-diamino-1,2-diphenylethane, 2,4-diaminodiphenylsulfone, 4,4'-diaminodiphenylsulfone, m-aminophenol, m-aminobenzylamine, benzyldimethylamine, 2-dimethylaminomethyl)phenol, triethanolphenol, methylbenzylamine, -(m-aminophenyl)ethylamine, -(p-aminophenyl)ethylamine, diaminodiethyldimethyldiphenylmethane, and ,'-bis(4-aminophenyl)-p-diisopropylbenzene.

Examples of the acid anhydride curing agent include dodecenyl succinic anhydride, polyadipic acid anhydride, polyazellainc acid anhydride, polysebacic acid anhydride, poly(ethyloctadecanoic acid)anhydride, poly(phenylhexadecanoic acid)anhydride, methyltetrahydro phthalic anhydride, methylhexahydro phthalic anhydride, hexahydro phthalic anhydride, anhydrous methyl hymic acid, tetrahydro phthalic anhydride, trialkyltetrahydro phthalic anhydride, methylcyclohexenedicarbonic acid anhydride, methylcyclohexenetetracarbonic acid anhydride, phthalic anhydride, anhydrous trimellitic acid, anhydrous pyromellitic acid, benzophenone tetracarbonic acid anhydride, ethylene glycol bistrimellitate, hetic anhydride, nadic anhydride, anhydrous methyl nadic acid, 5-(2,5-dioxotetrahydro-3-furanyl)-3-methyl-3-cyclohexane-1,2-dicarbonic acid anhydride, 3,4-dicarboxy-1,2,3,4-tetrahydro-1-naphthalene succinic acid dianhydride, and 1-methyl-dicarboxy-1,2,3,4-tetrahydro-1-naphthalene succinic acid dianhydride.

The epoxy resin compound includes 85 wt% to 97 wt% of the inorganic filler.

When the content of the inorganic filler is lower than the above range, it may be difficult to attain effects of the present disclosure such as high thermal conductivity, low thermal expansibility, and high thermal resistance. The more the content of inorganic filler is included; the above-mentioned effects can be attained but are not improved in proportion to the volume fraction of the inorganic filler. That is, the above-mentioned effects are significantly improved from a specific content of the inorganic filler. The above-described mentioned effects are obtained by controlled high order structure in a polymer state. It seems that a specific content of the inorganic filler is necessary because the higher order structure is mainly achieved on the surface of the inorganic filler. Meanwhile, when the content of the inorganic filler is greater than the above range, the viscosity of the epoxy resin compound may increase to make it difficult to form the epoxy resin compound in a desired shape.

The inorganic filler may have a globular shape. The shape of the inorganic filler is not limited as long as the inorganic filler has a globular shape. For example, the inorganic filler may have an elliptical sectional shape. However, as the shape of the inorganic filler is close to a perfect globular shape, the fluidity of the epoxy resin compound improves.

The inorganic filler may be alumina, aluminum nitride, silicon nitride, boron nitride, or crystalline silica, and the like. In addition, two or more different inorganic fillers may be used in combination as the inorganic filler.

The average particle diameter of the inorganic filler may be less than 30. When the average particle diameter is above the above range, the fluidity and strength of the epoxy resin compound are decreased.

The epoxy resin compound of the present disclosure may be mixed with a known curing accelerator. Examples of the curing accelerator include amines, imidazoles, organic phosphines, and Lewis acids. Specifically, examples of the curing accelerator may include: tertiary amines such as 1,8-diazabicyclo(5,4,0)undecene-7, triethylenediamine, benzyldimethylamine, triethanolamine, dimethylaminoethanol, and tris(dimethylaminomethyl)phenol; imidazoles such as 2-methylimidazole, 2-phenylimidazole, 2-phenyl-4-methylimidazole, and 2-heptadecylimidazole; organic phosphines such as tributylphosphine, methyldiphenylphosphine, triphenylphosphine, diphenylphosphine, and phenylphosphine; and tetra substituted phosphoniumtetra substituted borate such as tetraphenylphosphoniumtetraphenylborate, tetraphenylphosphoniumethyltriphenylborate, and tetrabutylphosphoniumtetrabutylborate; and tetraphneylboron salts such as 2-ethyl-4-methylimidazoletetraphenylborate, and N-methylmorphorlintetraphenylborate.

General wax may be used as a release agent for wax may be used as a release agent for the epoxy resin compound of the present disclosure. Examples of the wax include stearic acid, montanic acid, montanic acid ester, and phosphoric acid ester.

For the epoxy resin compound of the present disclosure, a coupling agent that is generally used for an epoxy resin compound may be used so as to improve the adhesion strength between the inorganic filler and the resin component. Examples of the coupling agent include an epoxy silane.

When the epoxy resin compound of the present disclosure includes the epoxy resin, the curing agent, and the inorganic filler as main components, the epoxy resin compound includes 3 wt% to 60 wt% of the epoxy resin, 85 wt% to 97wt% of the inorganic filler, and 0.5 wt% to 5wt% of the curing agent. The epoxy resin, the curing agent, and other components are dissolved in a solvent such as acetone, MEK, MIBK, IPA, butanol, or toluene and are agitated while applying heat. Then, then the inorganic filler is added to the solution is uniformly mixed using a device such as a mixer. Thereafter, the coupling agent is added to the mixture and the mixture is kneaded using a device such as a heating roll and a kneader. The mixing order of the above components is not limited.

At this time, the solvent is used in 10 wt% to 20 wt% based on the total weight of the epoxy resin compound.

The epoxy resin compound of the present disclosure is applied to a radiant heat circuit board 100 as shown in Fig. 1.

Referring to FIG. 1, the radiant heat circuit board 100 of the present disclosure includes a metal plate 110, an insulating layer 120 on the metal plate 110, circuit patterns 130 on the insulating layer 120.

The metal plate 110 may be formed of one of alloys including copper, aluminum, nickel, gold, platinum, and the like that have good thermal conductivity.

The metal plate 110 may include a metal projection (now shown) that constitutes a mounting pad on which a heat-generating device 150 is mounted.

The metal projection may extend vertically from the metal plate 110. The heat-generating device 150 is mounted on a portion of the topside of the metal projection, and the portion of the topside of the metal projection has a predetermined width so that solder balls can be placed.

The insulating layer 120 is disposed on the metal plate 110.

The insulating layer 120 may include a plurality of insulating layers. The insulating layer 120 is disposed between the metal plate 110 and the circuit patterns 130.

The insulating layer 120 may be formed by curing the above-described crystalline epoxy resin compound. An inorganic filler 125 is evenly dispersed in the insulating layer 120.

The circuit patterns 130 are disposed on the insulating layer 120.

Since the insulating layer 120 is formed of the above-described crystalline epoxy resin compound, the thermal conductivity of the insulating layer 120 is increased so that heat generated from the heat-generating device 150 can be transferred to the metal plate 110 through the insulating layer 120.

### <Examples>

Hereinafter, the scope of the present disclosure will be explained in more detail with reference to Examples.

The following examples 1, 2, 3, 4, 5, 6, 7, 8, 9 are not according to the invention and are present for illustration purposes only.

### (Example 1)

All of 10.7 wt% of Bisphenol-A, 3.2 wt% of o-cresol-novolac, 2.1 wt% of crystalline epoxy resin of Chemical Formula 2, 6.4 wt% of NC-3000, 1.8 wt% of biphenyl curing agent and epoxy resin, 0.3 wt% of imidazole-based curing accelerator, and 0.5 wt% of BYK-W980 additive were mixed; stirred at 40 for 10 minutes; then 74.9 wt% of alumina inorganic filer was added; and then stirred at room temperature for 20 to 30 minutes to obtain a crystalline epoxy resin compound of Example 1.

The thermal conductivity of the epoxy resin compound was measured by a unsteady hot wire method using LFA447 Type thermal conductivity meter available from NETZSCH Company.

The glass transition temperature of the epoxy resin compound was measured at a temperature increasing rate of 10/minute by using a DSC Q100 Thermo-mechanical measuring device available from TA Company.

### (Example 2)

All of 3.1 wt% of o-cresol-novolac, 7.3 wt% of NC-3000, 3.1 wt% of crystalline epoxy resin of Chemical Formula 2, 2.3 wt% of biphenyl curing agent, 0.2 wt% of imidazole-based curing accelerator, and 0.7 wt% of BYK-W980 additive were mixed; stirred at 40 for 10 minutes; then 83.2 wt% of alumina inorganic filer was added; and then stirred at room temperature for 20 to 30 minutes to obtain a crystalline epoxy resin compound of Example 2.

### (Example 3)

All of 1.9 wt% of Bisphenol-A, 7.5 wt% of crystalline epoxy resin of Chemical Formula 2, 4.4 wt% of NC-3000, 0.8 wt% of biphenyl curing agent, 0.1 wt% of imidazole-based curing accelerator, and 0.7 wt% of BYK-W980 additive were mixed; stirred at 40 for 10 minutes; then 84.3 wt% of alumina inorganic filer was added; and then stirred at room temperature for 20 to 30 minutes to obtain a crystalline epoxy resin compound of Example 3.

### (Example 4)

All of 1.8 wt% of Bisphenol-A, 12.2 wt% of crystalline epoxy resin of Chemical Formula 2, 4.4 wt% of NC-3000, 0.8 wt% of biphenyl curing agent, 0.1 wt% of imidazole-based curing accelerator, and 0.7 wt% of BYK-W980 additive were mixed; stirred at 40 for 10 minutes; then 80.0 wt% of alumina inorganic filer was added; and then stirred at room temperature for 20 to 30 minutes to obtain a crystalline epoxy resin compound of Example 4.

### (Example 5)

All of 0.9 wt% of Bisphenol-A, 6.4 wt% of crystalline epoxy resin of Chemical Formula 2, 4.6 wt% of NC-3000, 0.8 wt% of biphenyl curing agent, 0.1 wt% of imidazole-based curing accelerator, and 0.7 wt% of BYK-W980 additive were mixed; stirred at 40 for 10 minutes; then 86.5 wt% of alumina inorganic filer was added; and then stirred at room temperature for 20 to 30 minutes to obtain a crystalline epoxy resin compound of Example 5.

### (Example 6)

All of 10.7 wt% of Bisphenol-A, 3.2 wt% of o-cresol-novolac, 2.1 wt% of crystalline epoxy resin of Chemical Formula 3, 6.5 wt% of NC-3000, 1.8 wt% of TPP-K curing agent, 0.3 wt% of imidazole-based curing accelerator, and 0.5 wt% of BYK-W980 additive were mixed; stirred at 40 for 10 minutes; then 74.9 wt% of alumina inorganic filer was added; and then stirred at room temperature for 20 to 30 minutes to obtain a crystalline epoxy resin compound of Example 6.

### (Example 7)

All of 3.1 wt% of o-cresol-novolac, 3.1 wt% of crystalline epoxy resin of Chemical Formula 3, 7.4 wt% of NC-3000, 2.3 wt% of imidazole curing agent, 0.2 wt% of imidazole-based curing accelerator, and 0.7 wt% of BYK-W980 additive were mixed; stirred at 40 for 10 minutes; then 83.2 wt% of alumina inorganic filer was added; and then stirred at room temperature for 20 to 30 minutes to obtain a crystalline epoxy resin compound of Example 7.

### (Example 8)

All of 1.9 wt% of Bisphenol-A, 7.5 wt% of crystalline epoxy resin of Chemical Formula 3, 4.7 wt% of NC-3000, 0.8 wt% of imidazole curing agent, 0.1 wt% of imidazole-based curing accelerator, and 0.7 wt% of BYK-W980 additive were mixed; stirred at 40 for 10 minutes; then 84.3 wt% of alumina inorganic filer was added; and then stirred at room temperature for 20 to 30 minutes to obtain a crystalline epoxy resin compound of Example 8.

### (Example 9)

All of 1.8 wt% of Bisphenol-A, 10.6 wt% of crystalline epoxy resin of Chemical Formula 3, 4.4 wt% of NC-3000, 0.8 wt% of imidazole curing agent, 0.1 wt% of imidazole-based curing accelerator, and 0.7 wt% of BYK-W980 additive were mixed; stirred at 40 for 10 minutes; then 81.6 wt% of alumina inorganic filer was added; and then stirred at room temperature for 20 to 30 minutes to obtain a crystalline epoxy resin compound of Example 9.

### (Example 10)

All of 0.9 wt% of Bisphenol-A, 6.4 wt% of crystalline epoxy resin of Chemical Formula 3, 4.6 wt% of NC-3000, 0.8 wt% of imidazole curing agent, 0.1 wt% of imidazole-based curing accelerator, and 0.7 wt% of BYK-W980 additive were mixed; stirred at 40 for 10 minutes; then 86.5 wt% of alumina inorganic filer was added; and then stirred at room temperature for 20 to 30 minutes to obtain a crystalline epoxy resin compound of Example 10.

### (Comparative Example 1)

All of 17.1 wt% of Bisphenol-A, 2.7 wt% of Bisphenol-F, 2.7 wt% of o-cresol-novolac, 5.5 wt% of NC-3000, 2.5 wt% of phenol-based curing agent 0.5 wt% of imidazole-based curing accelerator, and 0.6 wt% of BYK-W980 additive were mixed; stirred at 40 for 10 minutes; then 70.6 wt% of alumina inorganic filer was added; and then stirred at room temperature for 20 to 30 minutes to obtain an epoxy resin compound of Comparative Example 1.

### (Comparative Example 2)

All of 11.8 wt% of Bisphenol-A, 3.5 wt% of Bisphenol-F, 3.5 wt% of o-cresol-novolac, 7.1 wt% of NC-3000, 2.5 wt% of phenol-based curing agent, 0.5 wt% of imidazole-based curing accelerator, and 0.6 wt% of BYK-W980 additive were mixed; stirred at 40 for 10 minutes; then 70.6 wt% of alumina inorganic filer was added; and then stirred at room temperature for 20 to 30 minutes to obtain an epoxy resin compound of Comparative Example 2.

### (Comparative Example 3)

All of 10.7 wt% of Bisphenol-A, 1.8 wt% of Bisphenol-F, 1.8 wt% of o-cresol-novolac, 3.6 wt% of NC-3000, 1.3 wt% of phenol-based curing agent, 0.5 wt% of imidazole-based curing accelerator, and 0.4 wt% of BYK-W980 additive were mixed; stirred at 40 for 10 minutes; then 80.0 wt% of alumina inorganic filer was added; and then stirred at room temperature for 20 to 30 minutes to obtain an epoxy resin compound of Comparative Example 3.

### (Comparative Example 4)

All of 10.7 wt% of Bisphenol-A, 5.3 wt% of o-cresol-novolac, 6.5 wt% of NC-3000, 1.8 wt% of TPP-K curing agent, 0.3 wt% of imidazole-based curing accelerator, and 0.5 wt% of BYK-W980 additive were mixed; stirred at 40 for 10 minutes; then 74.9 wt% of alumina inorganic filer was added; and then stirred at room temperature for 20 to 30 minutes to obtain an epoxy resin compound of Comparative Example 4.

### (Comparative Example 5)

All of 6.2 wt% of o-cresol-novolac, 7.4 wt% of NC-3000, 2.3 wt% of imidazole curing agent, 0.2 wt% of imidazole-based curing accelerator, and 0.7 wt% of BYK-W980 additive were mixed; stirred at 40 for 10 minutes; then 83.2 wt% of alumina inorganic filer was added; and then stirred at room temperature for 20 to 30 minutes to obtain an epoxy resin compound of Comparative Example 5.

### <Experimental Example>

### Measurement of Thermal Conductivity

Thermal conductivities of each Example and Comparative Example were measured by an unsteady hot wire method using LFA447 Type thermal conductivity meter available from NETZSCH Company, and the measured results are shown in Table 1.

### Measurement of Heat of Melting

Melting heat was measured at a temperature increasing rate of 10/minute using a differential scanning calorimeter (DSC Q100 available from TA Company), and the measured results are shown in Table 1. The melting heat is similar in each Example and Comparative Example.

### Glass Transition Temperature

Glass transition temperatures were measured at a temperature increasing rate of 10/minute by using a DSC Q100 Thermo-mechanical measuring device available from TA Company, and the measured results are shown in Table 1. The glass transition temperatures are at least 100. That is, other properties are not deteriorated although a crystalline epoxy resin is added.

### Table 1

**[Table 1]**

| Experiment No. | Thermal Conductivity(W/mK) | Glass Transition Temperature Tg |
|---|---|---|
| Example 1 | 2.14 | 122 |
| Example 2 | 2.43 | 132 |
| Example 3 | 4.93 | 124 |
| Example 4 | 6.98 | 122 |
| Example 5 | 5.43 | 125 |
| Comparative Example 1 | 0.63 | 104 |
| Comparative Example 2 | 1.52 | 115 |
| Comparative Example 3 | 2.865 | 124.78 |

Referring to Table 1, in Example 4 and Comparative Example 3 where the same amount of inorganic filler was used, the thermal conductivity of the crystalline epoxy resin compound of Example 4 including a crystalline epoxy resin is higher than the thermal conductivity of the epoxy resin compound of Comparative Example 3.

And referring to Table 2, in Example 6 and Comparative Example 4 where the same amount of inorganic filler was used, the thermal conductivity of the crystalline epoxy resin compound of Example 6 including a crystalline epoxy resin is higher than the thermal conductivity of the epoxy resin compound of Comparative Example 4. And Example 6 and Comparative Example 4 have the same result.

### Table 2

**[Table 2]**

| Experiment No. | Thermal Conductivity(W/mK) | Glass Transition Temperature Tg | Heat of Melting(J/g) |
|---|---|---|---|
| Example 6 | 1.6 | 132.9 | 221.6 |
| Example 7 | 2.1 | 142.6 | 228.5 |
| Example 8 | 3.2 | 145.1 | 225.2 |
| Example 9 | 3.6 | 150.9 | 218.4 |
| Example 10 | 5.1 | 148.3 | 226.3 |
| Comparative Example 4 | 1.1 | 129.7 | 228.3 |
| Comparative Example 5 | 1.6 | 137.2 | 235.4 |

Although embodiments have been described with reference to a number of illustrative embodiments thereof, it should be understood that numerous other modifications and embodiments can be devised by those skilled in the art that will fall within the subject-matter of the claims. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. An epoxy resin composition comprising an epoxy resin, a curing agent, and an inorganic filler,
wherein the epoxy resin includes a crystalline epoxy resin and a general amorphous epoxy resin in which a molecule has at least two epoxy groups,
wherein the epoxy resin composition comprises 3 wt% to 60 wt% of epoxy resin based on a total weight of the epoxy resin composition,
wherein the epoxy resin composition comprises 0.5 wt% to 5 wt% of the curing agent based on a total weight of the epoxy resin composition,
wherein the epoxy resin composition comprises 85 wt% to 97 wt% of inorganic filler based on a total weight of the epoxy resin composition,
wherein the cured epoxy resin composition has a thermal conductivity of at least 3 W/mK,
wherein the epoxy resin comprises at least 50 wt% of the crystalline epoxy resin,
**characterized in that** the crystalline epoxy resin is represented by the following chemical formula:

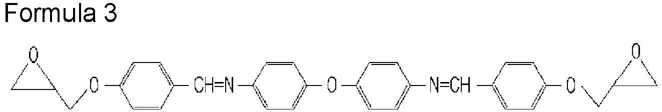

2. The epoxy resin composition according to claim 1, wherein the inorganic filler is at least one of alumina, boron nitride, aluminum nitride, crystalline silica, and silicon nitride.

3. A radiant heat circuit board (100) comprising:
a metal plate (110);
an insulating layer (120) on the metal plate (110); and
a circuit pattern (130) on the insulating layer (120),
wherein the insulating layer (120) is formed by curing an epoxy resin composition comprising epoxy resin, a curing agent, and an inorganic filler.
wherein the epoxy resin includes a crystalline epoxy resin and a general amorphous epoxy resin which a molecule has at least two epoxy groups,
wherein the epoxy resin composition comprises 3 wt% to 60 wt% of epoxy resin based on a total weight of the epoxy resin composition,
wherein the epoxy resin composition comprises 0.5 wt% to 5 wt% of the curing agent based on a total weight of the epoxy resin composition,
wherein the epoxy resin composition comprises 85 wt% to 97 wt% of inorganic filler based on a total weight of the epoxy resin composition,
wherein the cured
epoxy resin composition has a thermal conductivity of at least 3 W/mK
wherein the crystalline epoxy resin is is represented by the following chemical formula: 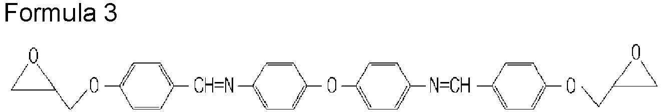
wherein the epoxy resin comprises at least 50 wt% of the crystalline epoxy resin.

4. The radiant heat circuit board (100) according to claim 3, wherein the inorganic filler is at least one of alumina, boron nitride, aluminum nitride, crystalline silica, and silicon nitride.

## Patentansprüche

1. Epoxidharzzusammensetzung, umfassend ein Epoxidharz, ein Härtungsmittel und einen anorganischen Füllstoff,
wobei das Epoxidharz ein kristallines Epoxidharz und ein allgemeines amorphes Epoxidharz beinhaltet, in dem ein Molekül mindestens zwei Epoxygruppen aufweist,
wobei die Epoxidharzzusammensetzung zu 3 Gew.-% bis 60 Gew.-% Epoxidharz basierend auf einem Gesamtgewicht der Epoxidharzzusammensetzung umfasst,
wobei die Epoxidharzzusammensetzung zu 0,5 Gew.-% bis 5 Gew.-% das Härtungsmittel basierend auf einem Gesamtgewicht der Epoxidharzzusammensetzung umfasst,
wobei die Epoxidharzzusammensetzung zu 85 Gew.-% bis 97 Gew.-% anorganischen Füllstoff basierend auf einem Gesamtgewicht der Epoxidharzzusammensetzung umfasst,
wobei die gehärtete Epoxidharzzusammensetzung eine Wärmeleitfähigkeit von mindestens 3 W/mK aufweist,
wobei das Epoxidharz mindestens zu 50 Gew.-% das kristalline Epoxidharz umfasst,
**dadurch gekennzeichnet, dass** das kristalline Epoxidharz durch die folgende chemische Formel dargestellt wird:
Formel 3

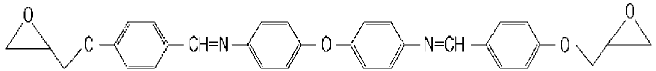

2. Epoxidharzzusammensetzung nach Anspruch 1, wobei der anorganische Füllstoff mindestens eines von Aluminiumoxid, Bornitrid, Aluminiumnitrid, kristallinem Siliciumdioxid und Siliciumnitrid ist.

3. Strahlungswärmeleiterplatte (100), umfassend:
eine Metallplatte (110);
eine Isolierschicht (120) auf der Metallplatte (110); und
ein Leitermuster (130) auf der Isolierschicht (120),
wobei die Isolierschicht (120) durch Härten einer Epoxidharzzusammensetzung ausgebildet wird, umfassend Epoxidharz, ein Härtungsmittel und einen anorganischen Füllstoff.
wobei das Epoxidharz ein kristallines Epoxidharz und ein allgemeines amorphes Epoxidharz beinhaltet, wobei ein Molekül mindestens zwei Epoxygruppen aufweist,
wobei die Epoxidharzzusammensetzung zu 3 Gew.-% bis 60 Gew.-% Epoxidharz basierend auf einem Gesamtgewicht der Epoxidharzzusammensetzung umfasst,
wobei die Epoxidharzzusammensetzung zu 0,5 Gew.-% bis 5 Gew.-% das Härtungsmittel basierend auf einem Gesamtgewicht der Epoxidharzzusammensetzung umfasst,
wobei die Epoxidharzzusammensetzung zu 85 Gew.-% bis 97 Gew.-% anorganischen Füllstoff basierend auf einem Gesamtgewicht der Epoxidharzzusammensetzung umfasst,
wobei die gehärtete Epoxidharzzusammensetzung eine Wärmeleitfähigkeit von mindestens 3 W/mK aufweist
wobei das kristalline Epoxidharz durch die folgende chemische Formel dargestellt wird: 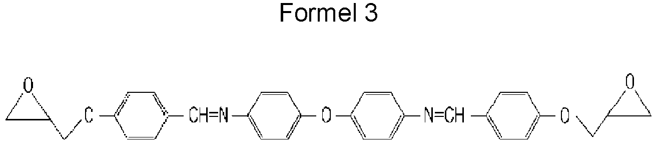
wobei das Epoxidharz mindestens zu 50 Gew.-% das kristalline Epoxidharz umfasst.

4. Strahlungswärmeleiterplatte (100) nach Anspruch 3, wobei der anorganische Füllstoff mindestens eines von Aluminiumoxid, Bornitrid, Aluminiumnitrid, kristallinem Siliciumdioxid und Siliciumnitrid ist.

## Revendications

1. Composition de résine époxy comprenant une résine époxy, un agent de durcissement et une charge inorganique,
la résine époxy comportant une résine époxy cristalline et une résine époxy généralement amorphe dans laquelle une molécule a au moins deux groupes époxy,
la composition de résine époxy comprenant 3 % en poids à 60 % en poids de résine époxy en fonction d'un poids total de la composition de résine époxy,
la composition de résine époxy comprenant 0,5 % en poids à 5 % en poids de l'agent de durcissement en fonction d'un poids total de la composition de résine époxy,
la composition de résine époxy comprenant 85 % en poids à 97 % en poids de charge inorganique en fonction d'un poids total de la composition de résine époxy,
la composition de résine époxy durcie ayant une conductivité thermique d'au moins 3 W/mK,
la résine époxy comprenant au moins 50 % en poids de la résine époxy cristalline,
**caractérisée en ce que** la résine époxy cristalline est représentée par la formule chimique suivante :

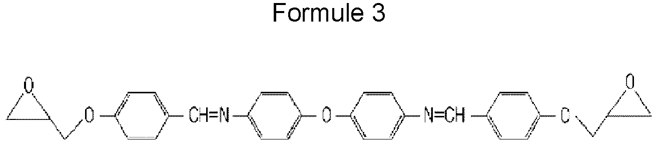

2. Composition de résine époxy selon la revendication 1, dans laquelle la charge inorganique est au moins l'une parmi alumine, nitrure de bore, nitrure d'aluminium, silice cristalline et nitrure de silicium.

3. Carte de circuit à chaleur rayonnante (100) comprenant :
une plaque en métal (110) ;
une couche isolante (120) sur la plaque en métal (110) ; et
un motif de circuit (130) sur la couche isolante (120),
la couche isolante (120) étant formée par durcissement d'une composition de résine époxy comprenant une résine époxy, un agent de durcissement et une charge inorganique.
la résine époxy comportant une résine époxy cristalline et une résine époxy généralement amorphe dont une molécule a au moins deux groupes époxy,
la composition de résine époxy comprenant 3 % en poids à 60 % en poids de résine époxy en fonction d'un poids total de la composition de résine époxy,
la composition de résine époxy comprenant 0,5 % en poids à 5 % en poids de l'agent de durcissement en fonction d'un poids total de la composition de résine époxy,
la composition de résine époxy comprenant 85 % en poids à 97 % en poids de charge inorganique en fonction d'un poids total de la composition de résine époxy,
la composition de résine époxy durcie ayant une conductivité thermique d'au moins 3 W/mK
la résine époxy cristalline étant représentée par la formule chimique suivante : 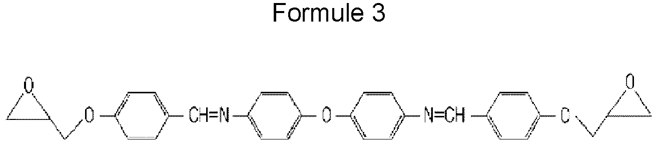
la résine époxy comprenant au moins 50 % en poids de la résine époxy cristalline.

4. Carte de circuit à chaleur rayonnante (100) selon la revendication 3, dans laquelle la charge inorganique est au moins l'une parmi alumine, nitrure de bore, nitrure d'aluminium, silice cristalline et nitrure de silicium.
